# EUROPEAN PATENT APPLICATION

(11) **EP 2 365 349 A1**
(43) Date of publication of application: **14.09.2011**
(21) Application number: 10075074.4
(22) Date of filing: 19.02.2010
(51) Int. Cl.: G01R 31/28, G01R 31/319

(54) **A test system for testing integrated circuits and an additional tester therefore**

(71) Applicant: Salland Engineering International BV, 8024 HA ZWOLLE (NL)
(72) Inventor: Looijen, Rien, Welsum (NL); Van Ulsen, Paul, 8014 BH Zwolle (NL); Stuij, Dirkjan, 8265 TE, Kampen (NL); Van Dam, Erik, 8251 VL Dronten (NL); Veltink, Gerwin, 7701 TJ Dedemsvaart (NL); Ramaker, Harry, 8026 PH Wythmen (NL)
(74) Representative: Prins, Hendrik Willem

(57) **Abstract**

The invention relates to a test system (1) for testing integrated circuits (ICs), such as mounted on a wafer, comprising: a main test system (2) comprising housed in a main frame a test computer for testing each IC for its performance in reaction to a test signal applied and contact means for making contact via test channels between the test computer and the ICs to be tested; and an additional tester (3) connected to the main frame and provided with additional test channels connected to the contact means and connected to the test computer for testing additional ICs, the additional tester comprises a cabinet (4) housing one or more power supply cards carrying a plurality of IC power supplies connected to a main power supply and to the additional test channels, each power supply card has a cooling system for cooling the IC power supplies carried, and has a calibration system for calibrating the output signal of each IC power supply, and to the additional tester.

## Description

The present invention relates to a test system for testing integrated circuits (ICs) and to an additional tester therefore.

After production and before transport and delivery an IC is to be tested and to be determined whether the IC performance meets the specification provided by the customer. The IC to be tested may be a single IC, a group of (semi)packaged ICs, and/or a group of ICs mounted on a wafer. An IC may have to be tested in relation one or more of its desired functions and thereto various input pins may have to be applied with different forced voltages and/or forced currents. Obviously, in order to shorten the time for testing the various forced voltages and/or currents may be applied sequentially or in parallel at the same time. In response the IC under testing will provide at the respective output pin an output signal which is to meet the specification. Accordingly, under performance testing the IC is to be provided at one or more input pins with a forced voltage and/or forced current and the responsive output signal (output voltage and/or output current) is to be measured and compared with the specification of the customer.

The testing capabilities of the present test systems are limited. For instances, some testing applications require more test channels connecting the test computer with the ICs to be tested. This has as a result that less ICs may be tested at the same time which increases the time period for testing and thus the overall time of production. In addition, there is a continuous development in increasing the number of ICs per wafer. Many variations are possible. For instance, wafers nowadays carry ICs in numbers of more than 2876 ICs, such as 3160 ICs, and even up to 5752 ICs. Practically any number of ICs to be tested is possible. This does not only apply to ICs mounted on a wafer, but also to (semi) packaged ICs. Even at lower numbers of mounted ICs the present test systems may run up to the limits of their testing capabilities when the testing of the IC requires testing of more than one IC performance and thus that more than one test channel is to make contact with a single IC (at various input ports) and apply the same or different forced currents and/or forced voltages. Another example of testing relates to the testing of ICs requiring higher forced current and various test channels are to be ganged. This will also reduce the testing capabilities of the existing test system.

Accordingly, there is a need for extending the testing capabilities of an existing test system other than by enlarging the number of test systems. The present invention has for its object to provide an improved test system of which the testing capabilities have been increased at substantially lower costs than for an additional test system. In essence the invention provides an add-on additional tester which provides a main test system with additional test capabilities and functions but still under the control of the main test system.

In order to meet this object the invention provides a test system for testing integrated circuits (ICs), such as mounted on a wafer, comprising:
a) a main test system comprising housed in a main frame a test computer for testing each IC for its performance in reaction to a test signal applied and contact means for making contact via test channels between the test computer and the ICs to be tested; and
b)an additional tester connected to the main frame and provided with additional test channels connected to the contact means and connected to the test computer for testing additional ICs, the additional tester comprises a cabinet housing one or more power supply cards carrying a plurality of IC power supplies connected to a main power supply and to the additional test channels, each power supply card has a cooling system for cooling the IC power supplies carried, and has a calibration system for calibrating the output signal of each IC power supply.

This additional tester provides the additional testing capabilities in the form of one or more power supply cards carrying a plurality of IC power supplies. It is this plurality of additional IC power supplies that corresponds to the additional testing capabilities. However, each of these additional IC power supplies is to be connected via connecting means comprising additional test channels, and is also to be connected to the test computer. Still programming and control of the additional IC power supplies will be in the same way as for IC power supplies of the main test system.

The additional tester comprises a cabinet in which the one or more power supply cards are mounted in a traditional racked fashion. The plurality of IC power supplies carried by the power supply card will generate heat which is to be dissipated. Standard cooling may be used as long as the cooling will not interfere with the functionality and operation of the power supply card housed in the cabinet. In addition the cooling may not result in a unreasonable increase of costs.

As mentioned above, ICs to be tested may be such that different ICs are tested under different testing conditions. ICs may be tested at low forced voltage and/or current, may be tested sequentially or concomitantly with more than one forced voltage and/or forced current, or tested with a number of ganged IC power supplies. This implies that the IC power supplies may be operating at the same time under mutually different low or stringent conditions and thus generate respectively more or less heat. The neighbouring IC power supplies may influence one another . Still the IC to be tested is to be applied with the correct forced voltage and/or forced current in order to determine whether the customer specification is met. Accordingly, the power supply card is provided with a calibration system for calibrating the output system of each IC power supply depended on the actual (temperature) conditions the IC power supply is actually operating.

It will be apparent to the skilled person that an additional tester according to the invention will enlarge the testing capabilities of the main test system in an elegant manner, at low costs, without requiring major investments in space, adaptation of the main test computer, and is relatively easy to install.

Test system according to the invention may comprise the power supply card carrying the number of additional power supplies that meet the needs for the extension of the testing capabilities. Generally the power supply carries a number of additional power supplies that can be operated under the most stringent conditions (maximal heat generation) as the cooling system can dissipate such that the temperature of all functional components on the power supply card is within their specification. Accordingly, it is preferred that the power supply card carries 16, 32, 64, 128, 256 or 512 IC power supplies. Practically, the number is in the range of 20 to 500 IC power supplies, such as 50 to 300 IC power supplies, although 32, 64 or 128 IC power supplies on a standard seized circuit board appeared advantages in view of size (in particular height) and component density of the power supply card.

Obviously, there is no need that all IC power supplies are carried by one single power supply card. Generally standard size circuit boards are used and the IC power supplies are distributed over several power supply cards, preferably of identical lithographic lay out. This is beneficial for instalment and for control and functioning by the test computer of the main test system. When also taking into account the dimensions of the main frame of the standard main test system and accordingly the dimensions of the cabinet then it is advantages when the cabinet houses in slots 2 ― 16 power supply cards, preferably 4 ― 12 power supply cards.

It will be apparent that the size and dimensions of the cabinet and the main frame will have impact on the allowable size of the type of cooling system. In principle any type of cooling system may be used, such as liquid (water) cooling and the like. However, such cooling may require additional cooling machines which will occupy floor space. Sufficient cooling capacity is required because the cooling capacity is directly related to the number of heat generating IC power supplies per power supply card and the number of cards that can be stored within the confinement of the cabinet. Accordingly, it was found advantageous when the cooling system comprises a cooling plate extending over the plurality of IC power supplies on the power supply card, and heat exchange means for dissipating heat, such as fans, cooling ribs and baffles. By cooling the plurality of IC power supplies has the advantage that differences in heat generated by IC power supplies functioning at different conditions is equalized, such that local differences in temperature are elegantly compensated and cooling capacity of adjacent may be used for cooling neighbouring high performing IC power supplies. This cooling plate has advantageously a relatively low height allowing racking power supply cards at relatively small distances from one other in slots. The optional heat exchange means contribute marginally to the height of the power supply card. When under stringent conditions equilibration of heat might become less optimal then it is preferred that the cooling plate is provided with heat equilibrating means, such as heat pipes. Such heat pipes are partially liquid filled and may extend in any direction relative to the IC power supplies to be cooled. Preferably, they extend relative to a cooling gas stream transverse thereto.

As indicated above the calibration system is used for calibrating the forced current or forced voltage of the IC power supply dependent on its (heat) conditions. This will greatly improve the testing quality. In this respect it is further preferred that the calibration system comprises a temperature sensor which is in heat contact with a IC power supply for temperature dependent adjustment of the output signal, and preferably the temperature adjustment of the output signal is determined as a function of the temperature behaviour of the IC power supply at different temperatures.

In order to reduce the adaptation of the main test system to a minimum and have the test computer allow to test via the standard test channels and via the additional test channels in an elegant manner, it is preferred that the additional test channels are aligned with the test channels, and the test channels and additional test channels are integrated in the contact means, which preferably comprise pogo means, such as pogo pins, connected to a probe card to be connected to the test object, such as a wafer. By the alignment of the two types of test channels it is possible to use a compact and reliable (small) number of adapted connection means. In this respect it is preferred that the pogo means comprise an annular pogo tower in which the test channels and additional test signals are aligned in sectors and/or the pogo means comprise at least one pogo block for connecting the test channels and additional test channels via an interface board to the pogo tower. Accordingly, adaptation of the testing capabilities remains possible in a relatively simple manner.

The standard test systems are designed to be used in any arrangement is as dictated by the IC handling machine, such as a wafer probing apparatus. In order to adapt to the high freedom of operation of the standard test system it is preferred that the additional tester may be used in any position, such as slanted and upside-down. Manipulation and handling of the test system of the invention is optimal if the main frame is connectable via a yoke to a manipulator for mounting for contacting to the wafer to be tested.

A further aspect of the invention relates to the additional tester for a test system for testing integrated circuits (ICs), such as mounted on a wafer, as described hereinbefore. The additional tester is in essence a "back pack" that is attached to the main frame of the main test system. It requires no additional floor space, whereas the contact means are reliable and in a compact manner integrated with the main test system and by alignment and elegant adaptation of the contact means the genuine function of the main test system is hardly interfered.

Mentioned and other features of the test system and additional tester according to the invention will be further illustrated by several embodiments which are given for information purposes only and are not intended to limit the invention to any extent. In relation to these embodiments reference will be made to the annexed figures of which:
figure 1 is an exploded view of the test system of the invention comprising the main test system, the additional tester and adapted contact means;
figure 2 is a perspective view of the partially assembled test system shown in figure 1;
figure 3 is a view according to arrow III in figure 2;
figure 4 is a more detailed view according to arrow IV in figure 3;
figure 5 schematically the set up of the test system of the invention;
figure 6 A - F schematically the cooling system;
figure 7 shows globally the layout of a power supply card;
figure 8 shows schematically the alignment of the connection means in cross section;
figure 9 shows a schematic, partially cut away top view according to arrow IX in figure 8;
figure 10 A - D at a larger scale various embodiments of the pogo tower; and
figure 11 A and B a perspective views of the manipulation of the test system of the invention.

The test system 1 of present invention will be described hereafter in combination with as main test system 2 a Teradyne™ J750. However, the skilled will appreciate that the additional tester 3 of the invention will equally suitable for use with other types of main test systems.

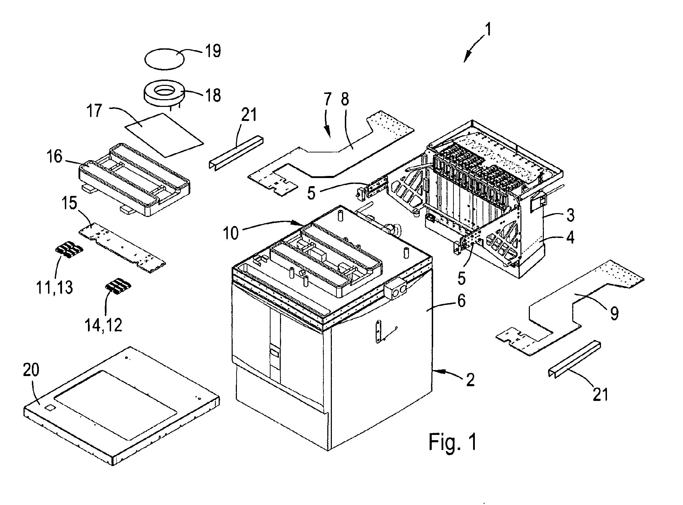

Figure 1 shows the test system 1 of the invention comprising the combination of a main test system 2 and the tester 3 of the invention. The tester 3 comprises a cabinet 4 which is connected by two yokes 5 to the main frame 6 of the main test system 2. The contact means 7 comprise two lateral signal boards 8 and 9 which connect at the test head 10 of the main test system 2 with pogo blocks 11 and 12. The pogo blocks 11 and 12 align with pogo block 13 and 14 of the main test system 2. The pogo blocks 11, 12, 13 and 14 rest on an alignment plate 15 which supports on a test head stiffener 16 applied on the test head 10. Via a probe interface board 17 and a pogo tower 18 the contact means 7 make contact with a fixed probe card 19 that ultimately make contact with the ICs to be tested. The construction is covered by a cover plate 20 and the signal boards are laterally supported by strips 21.

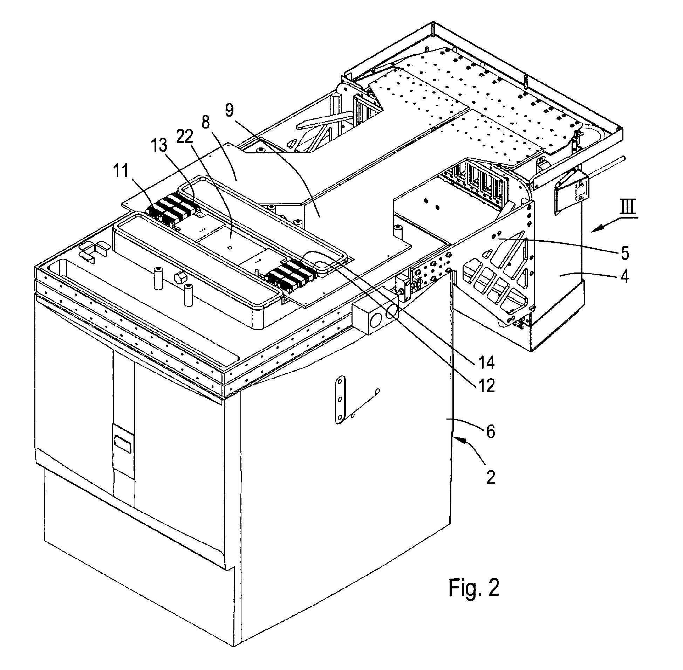

Figure 2 shows the partially assembled test system 1 of the invention. It is illustrated how the additional test channels (not shown) incorporated in the signal boards 8 and 9 align in the pogo blocks 11 and 12 with the test channel incorporated in the pogo blocks 13 and 14 of the main test system 2. Still an application space 22 is left open and available for other devices if so desired.

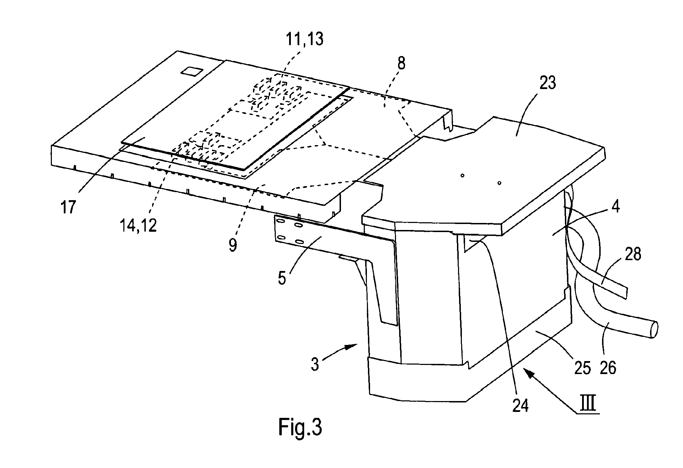

Figure 3 shows from another angle the tester 3 of the invention. The cabinet 4 is connected to the main frame 6 (see figures 1 and 2) via yokes 5. The cabinet 4 has a cover 23 covering partially the signal boards 8 and 9 and leaves a ventilation slot 24 open with a back door 25. A power cable 26 provides power to the tester 3 which is connected to the system power supply 27 (figure 11) via an interface cable 28.

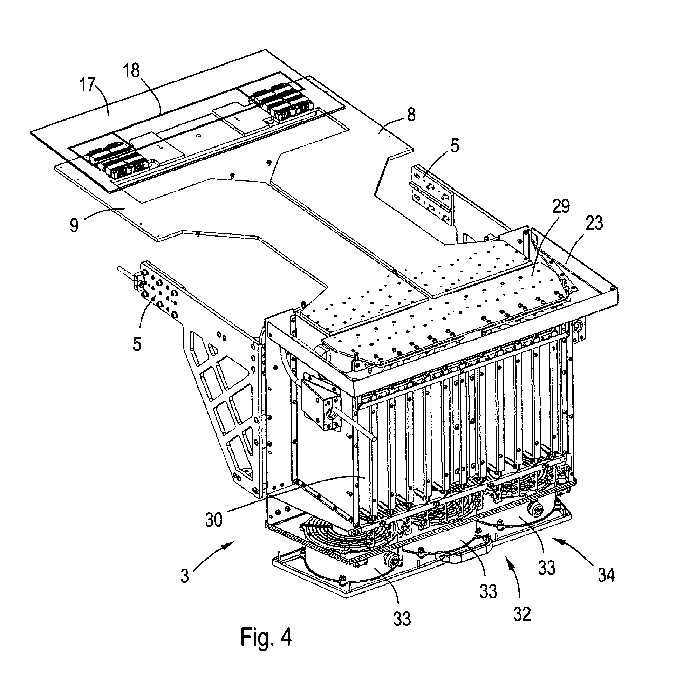

Figure 4 shows more in detail the tester 3. In housing are arranged 10 slots 30 for the power supply cards 31 and one additional slot for a computer interface. When arranged in a slot 30 the power supply card makes contact with the signal boards 8 and 9 via a back plate 29. Beneath the slots 30 are arranged fans 33 which are comprised by the heat exchange means 32 which are part of the cooling means 34.

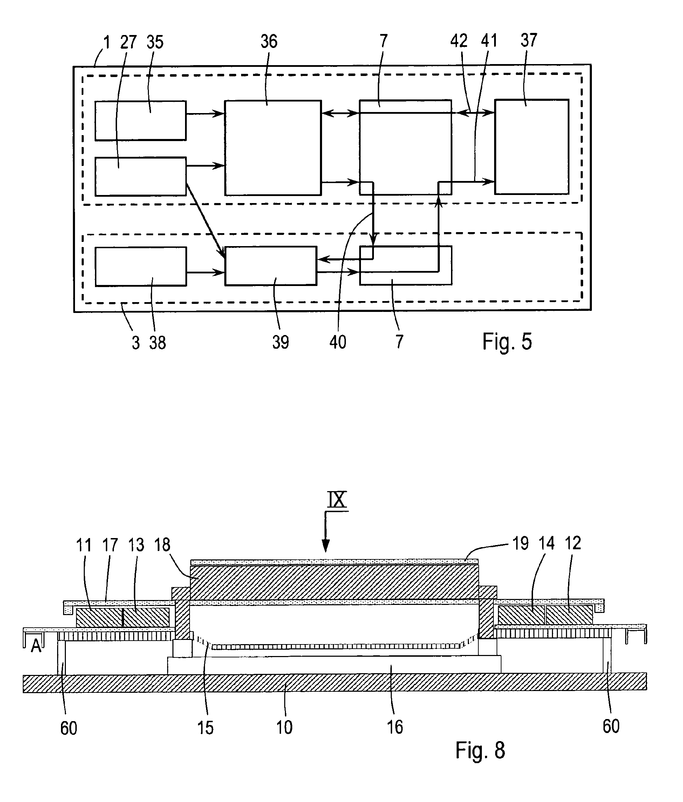

Figure 5 shows the setup of the test system 1 of the invention. The main test system 2 comprises a AC power vault 35 and the test computer both connected to the test unit 36 which is via the contact means 7 to be connected to the device under test 37 (the IC). The tester 3 comprises a power unit 38 for the test unit 39. The test unit 39 is via the test unit 36 and the control line 40 under real time functional control of the computer 27 which also controls the test unit 39. Thereby, is the test computer 27 provided with additional test channels 41 incorporated in the contact means 7. This means that via additional test channels 41 ICs 37 can be tested by the computer 27 of the main test system 2. The response signals of the ICs under test are passed through the channels 42 to the test unit of the tester 3. Here the response signals are compared with the specification for the IC under testing.

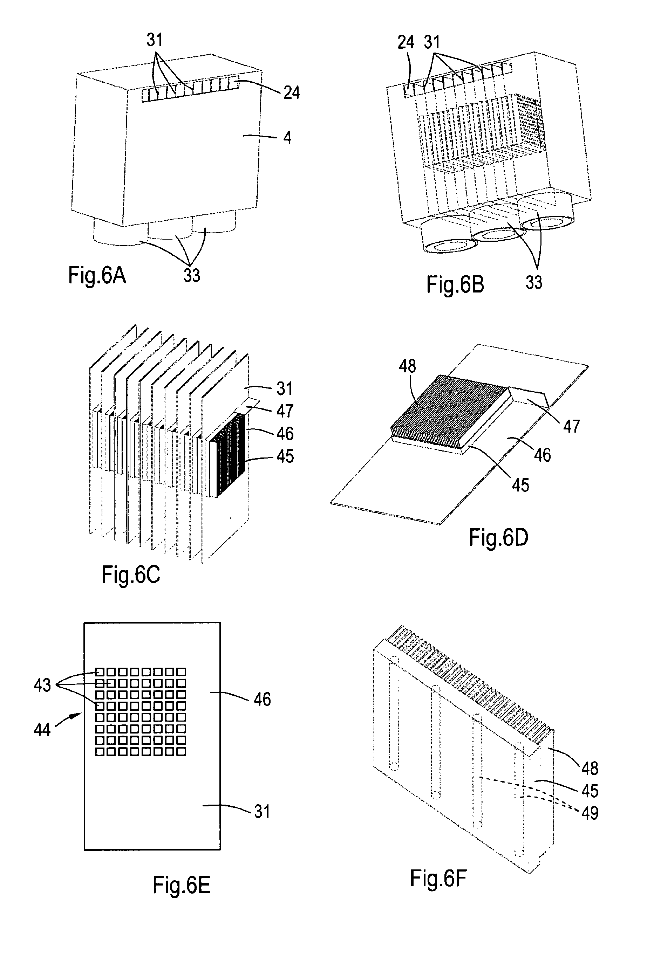

Figure 6 shows schematically the construction of the cooling means 34 of the invention which are incorporated in the cabinet 4. The cabinet comprises the ventilation slot 24 via which cooling gas (such as cooling air) is sucked in by the fans 33. The three fans 33 are sufficient for cooling 10 power supply cards 31. As shown in figure 6E, the power supply card 31 carries 64 IC power supplies 43 arranged in an array 44. This array 44 is covered by a cooling plate 45 which is in heat transfer contact with the array of IC power supplies 43. The power supply card 31 is broader than the array 44 and the cooling plate 45. The left passage 46 is blocked by a baffle 47. Accordingly, gas sucked in via the fans 3 is passed along and over the cooling plate 45. The cooling capacity of the cooling plate 45 is increased by applying cooling ribs 48 thereby increasing the heat exchange surface. Finally, the cooling plate is provided with heat pipes 49 extending in the direction of gas flow. The heat pipes 49 are filed with low boiling liquid so that evaporation and condensation at hot and cool ends, respectively results in a equalizing effect on a possible heat gradient over the cooling plate 45.

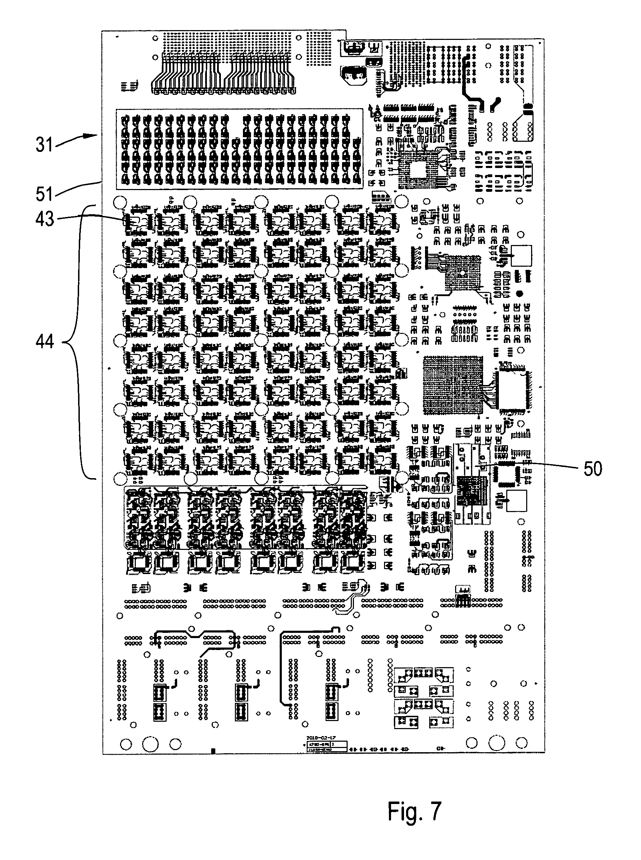

Figure 7 shows the global layout of the power supply card 31 of the invention. The card 31 comprises channel output relay 51 connecting the IC power supplies 43 from the array 44 via the back plate 29 with the lateral signal boards 8 and 9. The card 32 comprises further a calibration system 50 which comprises sensors (not shown) which monitor the temperature of each IC power supply 43 and in dependence on the actual value of the monitored temperature calibrate by increase or decrease of the forced current of forced voltage such that the IC power supply 43 provides the correct forced current or voltage to the IC to be tested. Thereto the calibration system 50 comprises soft ware describing the temperature behaviour of the IC power supply 43 and relating components as a function of the temperature. Having measured that behaviour at different temperatures allows for an accurate calibration or correction of the forced current and/or forced voltage. The power supply card 31 also comprises it own main power supply (not shown).

The cooling system 34 is designed such that heat generated under stringent conditions is dissipated thereby maintaining the IC power supplies 43 at near the desired operating temperature. The cooling capacity is such that the overvoltage (cables and channels) in combination with the forced voltage (dut voltage) required for IC testing is to be dissipated when the IC (or ICs) to be tested is in a short cut state or mode. At a combined voltage of about 13 Volt and with 64 IC power supplies 43 on the power supply card 31 requires a cooling capacity of about 350 -450W per card 31.

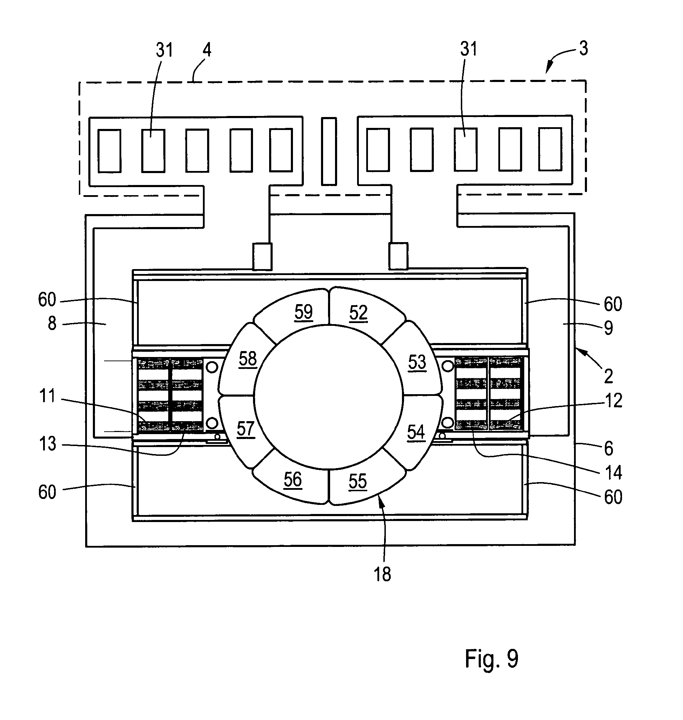

The figures 8 ― 10 show the alignment of the test channels 42 and the additional test channels 41. The power supply cards 31 arranged in the cabinet 4 of the tester 3 are connected via the signal boards 8 and 9 comprising the additional channels 41 from each IC power supply to the pogo blocks 11 and 12, which are aligned with the pogo blocks 13 and 14 comprising the test channels 42 of the main test system 2. The pogo blocks 11 ― 14 (comprising spring loaded pins arranged in openings of the pogo bocks 11-14) are connected via the interface board 17 with the pogo tower 18 which carries the fixed probe card 19. As shown in figure 9, has the pogo tower 18 an annular shape and is divided in eight sectors 52―59. The sectors 57 and 59 are available for the pogo block 11, the sectors 53 and 55 for the pogo block 12, the sectors 56 and 58 for the pogo block 13, and the sectors 52 and 54 for the pogo block 14. Dependent on the additional test channels 41 required can the various sector of the pogo tower 18 filled with pogo pins for making the connection with the fixed probe card. The alignment plate 15 is supported by the stiffener 16 and supports 60.

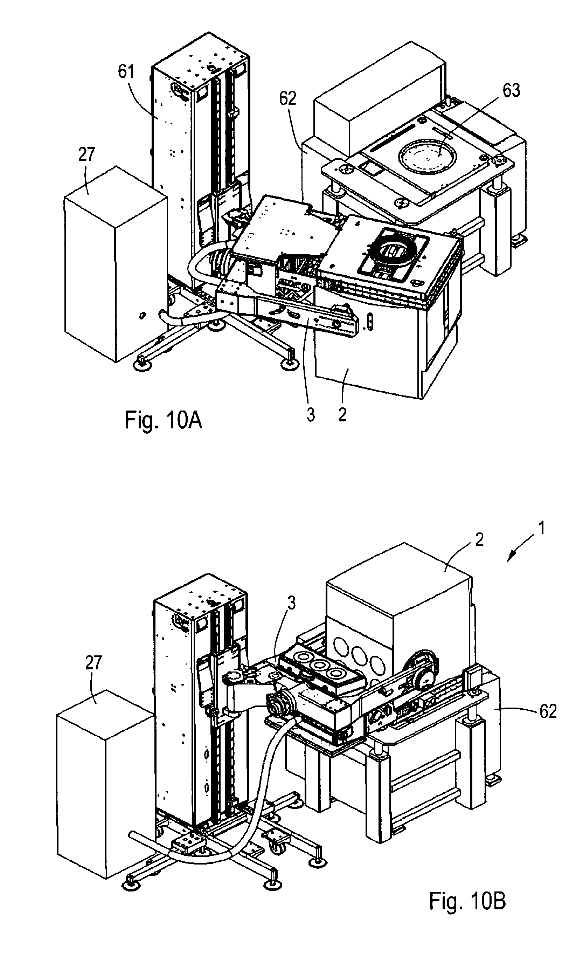

Finally, figures 10A and 10B show the manipulation of the test system 1 of the invention. The manipulator 61 is able to arrange the test system 1 in an upside-down orientation on an apparatus 62 comprising ICs to be tested, which can be approached via an opening 63 at which the fixed probe card 19 can make contact.

Accordingly, it is possible according to the invention that new or existing main test systems 2 can be relatively simple and at reasonable costs be adapted for testing more than the main test system 2 can test by the inclusion of the tester 3 providing additional test channels. The tester 3 has a construction such that although operating at relatively high heat dissipating conditions by effective cooling and calibration testing within customer's specification is possible.

## Claims

1. Test system for testing integrated circuits (ICs), such as mounted on a wafer, comprising:
a) a main test system comprising housed in a main frame a test computer for testing each IC for its performance in reaction to a test signal applied and contact means for making contact via test channels between the test computer and the ICs to be tested; and
b) an additional tester connected to the main frame and provided with additional test channels connected to the contact means and connected to the test computer for testing additional ICs, the additional tester comprises a cabinet housing one or more power supply cards carrying a plurality of IC power supplies connected to a main power supply and to the additional test channels, each power supply card has a cooling system for cooling the IC power supplies carried, and has a calibration system for calibrating the output signal of each IC power supply.

2. Test system according to claim 1, wherein the power supply card carries 16, 32, 64, 128, 256 or 512 IC power supplies connected to a corresponding number of additional test channels.

3. Test system according to claim 1 or 2, wherein the cabinet houses in slots 2 ― 16 power supply cards, preferably 4 ― 12 power supply cards.

4. Test system according to claim 1 ― 3, wherein the cooling system comprises a cooling plate extending over the plurality of IC power supplies on the power supply card, and heat exchange means for dissipating heat, such as fans, cooling ribs and baffles.

5. Test system according to claim 4, wherein the cooling plate is provided with heat equilibrating means, such as heat pipes.

6. Test system according to claim 1 - 5, wherein the calibration system comprises a temperature sensor which is in heat contact with a IC power supply for temperature dependent adjustment of the output signal, and preferably the temperature adjustment of the output signal is determined as a function of the temperature behaviour of the IC power supply at different temperatures.

7. Test system according to claim 1 - 6, where in the additional test channels are aligned with the test channels, and the test channels and additional test channels are integrated in the contact means, which preferably comprise pogo means connected to a probe card to be connected to the test object, such as the wafer.

8. Test system according to claim 7, wherein the pogo means comprise an annular pogo tower in which the test channels and additional test signals are aligned in sectors.

9. Test system according to claim 8, wherein the pogo means comprise at least one pogo block for connecting the test channels and additional test channels via an interface board to the pogo tower.

10. Test system according to claim 1 - 8, wherein the main frame is connectable via a yoke to a manipulator for mounting for contacting to the wafer to be tested.

11. Additional tester for a test system for testing integrated circuits (ICs) mounted on a wafer as defined in claims 1 ― 10.
